# EUROPEAN PATENT SPECIFICATION

(11) **EP 1 715 678 B1**
(45) Date of publication and mention of the grant of the patent: **09.06.2010**
(21) Application number: 06251943.4
(22) Date of filing: 06.04.2006
(51) Int. Cl.: H04N 5/335, H04N 3/15, H01L 27/146

(54) **Selective smile formation under transfer gate in a CMOS image sensor pixel**
Selektive Herstellung von Smiles unter Übertragungsgatter in einem CMOS-Bildsensorpixel
Formation sélective de smiles dans une grille de transfert CMOS dans un pixel d'un capteur d'images

(30) Priority: 22.04.2005 US 112289
(43) Date of publication of application: 25.10.2006
(73) Proprietor: OmniVision Technologies, Inc., Sunnyvale, California 94089 (US)
(72) Inventor: Nagaraja, Satyadev H, San Jose, California 95128 (US)
(74) Representative: Hackney, Nigel John

(56) References cited:
- WO-A-00/21280
- US-A1- 2001 055 849
- US-A1- 2002 008 767
- US-A1- 2004 075 110
- US-B1- 6 329 233
- US-B1- 6 351 002

## Description

The present invention relates to image sensors, and more particularly, to an image sensor that uses pixels having a transfer gate with an underlying asymmetric bird's beak smile.

Image sensors have become ubiquitous. They are widely used in digital still cameras, cellular phones, security cameras, medical, automobile, and other applications. The technology used to manufacture image sensors, and in particular CMOS image sensors, has continued to advance at great pace. For example, the demands of higher resolution and lower power consumption have encouraged the further miniaturization and integration of the image sensor.

WO00/21280 discloses active pixel sensors which are fabricated using a silicon-on-insulator (SOI) process by integrating photodetectors on a SOI substrate and forming pixel read-out transistors on an SOI thin-film.

US6329233 discloses a method for manufacturing a photodiode CMOS image sensor in which a first well and a second well are formed in a first type substrate.

US2002/0008767 discloses a CMOS image unit pixel layer having a photodiode which includes an optically optimised square imaging sensing region.

US2004/0075110 discloses a method of forming CMOS image sensors in the manufacture of an integrated circuit device.

Possibly as a result of the greater miniaturization and integration of the image sensor, various issues for both CMOS and CCD image sensors have arisen. For example, image lag and leakage current are important issues that need to be improved upon. As greater integration takes place, leakage current from a floating diffusion (also known as floating node) may become problematic. Specifically, leakage current through the channel-LDD (lightly doped drain) junction may occur. Additionally, image lag due to insufficient transfer of signal from the photodiode, through the channel of the transfer transistor, to the floating node is also an issue.

These and other issues related to greater integration need to be addressed.

Accordingly, in a first aspect, the present invention provides a method of forming an active pixel according to claim 1.

### BRIEF DESCRIPTION OF THE DRAWINGS

Figure 1 is a cross-sectional view of a prior art four transistor (4T) pixel which shows in detail a photodiode formed in a substrate.
Figures 2-5 are cross-sectional views of a process for forming a photodiode and pixel in accordance with the present invention.

### DETAILED DESCRIPTION

In the following description, numerous specific details are provided in order to give a thorough understanding of embodiments of the invention. One skilled in the relevant art will recognize, however, that the invention may be practiced without one or more of the specific details, or with other methods, components, materials, etc. In other instances, well known structures, materials, or operations are not shown or described in order to avoid obscuring aspects of the invention.

References throughout the specification to "one embodiment" or "an embodiment" means that a particular feature, structure, or characteristic described in connection with the embodiment and included in at least one embodiment of the present invention. Thus, the appearances of the phrase "in one embodiment" or "in an embodiment" in various places throughout the specification are not necessarily all referring to the same embodiment. Furthermore, the particular features, structures, or characteristics may be combined in any suitable manner in one or more embodiments.

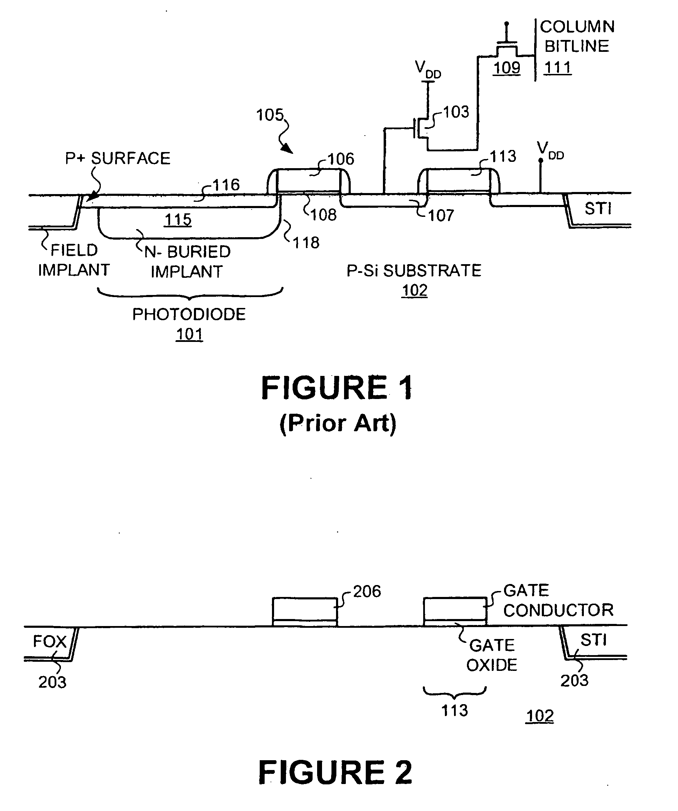

Figure 1 shows a cross-sectional view of a prior art active pixel that uses four transistors. This is known in the art as a 4T active pixel. However, it can be appreciated that the photodiode design and process of the present invention can be used with any type of pixel design, including but not limited to 4T, 5T, 6T, and other designs. Further, the photodiode design of the present invention may also be used in connection with charge coupled device (CCD) imagers. The photodiode may also be a partially pinned photodiode.

A photodiode 101, outputs a signal that is used to modulate an amplification transistor 103. The amplification transistor 103 is also referred to as a source follower transistor. In this embodiment, the photodiode 101 can be either a pinned photodiode or a partially pinned photodiode. The photodiode 101 comprises a N⁻ layer 115 that is a buried implant. Additionally, in one embodiment, a shallow P⁺ pinning layer 116 is formed at the surface of the semiconductor substrate 102.

It should be noted that the semiconductor substrate 102 is a p-type silicon substrate, but in other embodiments may be an n-type silicon substrate. Further, various structures are formed atop of and into the silicon substrate 102. For example, the photodiode 101 and the floating node 107 are formed into the silicon substrate 102. These structures are said to be formed below the surface of the silicon substrate by the use of dopants. Similarly, field oxides or shallow trench isolation structures are also formed at and below the top surface (or simply surface) of the silicon substrate.

In contrast, other structures, such as the gate oxide 108, the transfer gate 106, the transfer transistor 105, and the reset transistor 113 are formed atop of the silicon substrate 102 and are said to be at or above the top surface of the silicon substrate.

A transfer transistor 105 is used to transfer the signal output by the photodiode 101 to a floating node 107 (N+ doped), which is adjacent to the gate of the transfer transistor 105. The transfer transistor 105 is controlled by a transfer gate 106. The transfer transistor 105 also has a gate oxide 108 underneath the transfer gate 106.

In operation, during an integration period (also referred to as an exposure or accumulation period), the photodiode 101 stores charge that is held in the N⁻ layer 115. After the integration period, the transfer transistor 105 is turned on to transfer the charge held in the N- layer 115 of the photodiode 101 to the floating node 107. After the signal has been transferred to the floating node 107, the transfer transistor 105 is turned off again for the start of a subsequent integration period.

The signal on the floating node 107 is then used to modulate the amplification transistor 103. Finally, an address transistor 109 is used as a means to address the pixel and to selectively read out the signal onto a column bitline 111. After readout through the column bitline 111, a reset transistor 113 resets the floating node 107 to a reference voltage. In one embodiment, the reference voltage is V_{dd}. As seen in Figure 1, the N⁻ layer 115 is linked to the transfer transistor 105 by a narrow neck region 118.

The present invention will now be described in connection with Figures 2-5. Turning to Figure 2, a semiconductor substrate 102 is shown. In one embodiment, the semiconductor substrate 102 is a silicon substrate. A standard isolation 203, such as a LOCOS field oxide, or a shallow trench isolation (STI) defines an active area within the semiconductor substrate 102. In Figure 2, a field oxide is shown at one boundary and a STI is shown at another boundary of the pixel. This is meant to be illustrative of two different types of isolations, and in many embodiments, the boundary around a pixel will either be completely STI or completely LOCOS field oxide or completely another variety of isolation. In one embodiment, the field oxide or shallow trench isolation is lined with a P-type field implant. The isolation 203 is used to electrically isolate an active area that will contain a pixel.

Still referring to Figure 2, a transistor gate stack is deposited and etched to form a stack of gate oxide/polysilicon (conductor). In one embodiment, the transistor gate stack is formed by the deposition or growth of a relatively thin gate oxide layer using conventional semiconductor processing methods, such as thermal growth or chemical vapor deposition. Next, a conductive layer, such as a polysilicon layer, is deposited over the gate oxide layer. The polysilicon layer (when patterned, etched, and possibly doped) will serve as the gate of the various transistors such as the transfer transistor 105 or the reset transistor 113.

After deposition of these two layers, the stack is patterned and etched to leave the gate stack structures shown in Figure 2. These two structures will eventually form the transfer gate 206 and the gate of the reset transistor 113.

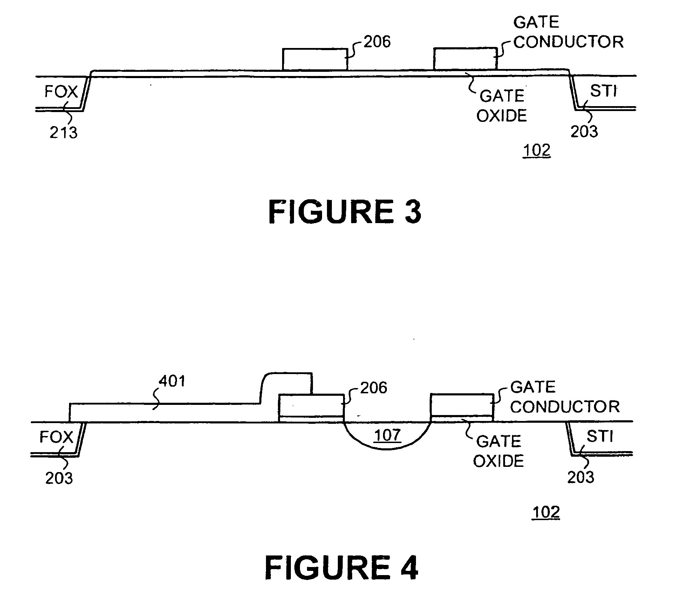

The present invention utilizes the selective formation of "smiles" (also referred to as a bird's beak) during a re-oxidation of the polysilicon transfer gate 206. As known by those skilled in the art, a bird's beak results from the lifting of a layer (such as polysilicon or nitride) due to an oxidation process. See www.sematech.org. This re-oxidation can occur and be implemented in several locations in the process flow. For example, turning to Figure 3, in one alternative embodiment, the gate stacks are formed by only etching the polysilicon layer and not the underlying gate oxide layer. In this embodiment, the gate oxide layer is left on the surface of the semiconductor substrate 102.

Using either Figure 3 or Figure 2 as a starting point, a protective layer 401 (seen in Figure 4) is deposited, patterned, and etched such that the protective layer 401 covers the interface between the transfer gate and the photodiode region. In one embodiment, the protective layer 401 is a nitride layer having a thickness of approximately 500 angstroms. However, it can be appreciated that other protective layers may also be used. One important consideration is that the interface between the transfer gate and the photodiode be protected from a subsequent re-oxidation step. While the protective layer 401 is shown extending to the field oxide 203, this is not absolutely necessary. Thus, Figure 4 is merely illustrative of a single embodiment of the present invention.

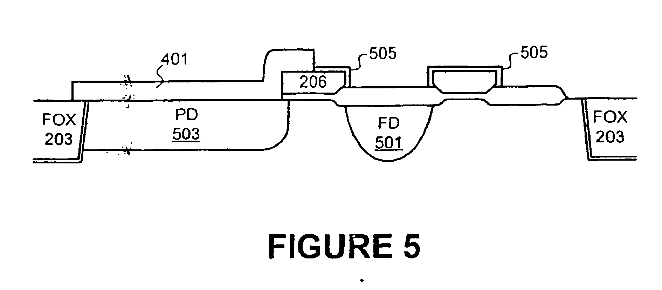

Next, turning to Figure 5, a re-oxidation process is performed which will result in a thickening of the gate oxide near the floating diffusion 107 and transfer gate 206. In one embodiment, the re-oxidation is performed using a rapid thermal oxidation (RTO) process. This thickened gate oxide near the floating diffusion is beneficial as it reduces the leakage current through the channel-LDD junction. It prevents leakage of charge from the floating diffusion. However, near the photodiode interface with the transfer gate 206, there is no thickening of the gate oxide. This absence of a bird's beak at that location will enhance the electrical field. This increases the coupling between the N⁻ region of the photodiode and the channel under the transfer gate. This facilitates the speedy and efficient transfer of the accumulated signal in the N⁻ region of the photodiode to the floating node 501.

Thus, turning to Figure 5, after the re-oxidation step, the oxide above the floating diffusion 501 is thickened causing a bird's beak structure to be formed at the interface between the floating diffusion 501 and the transfer gate 206. Because of the protective layer 401, there is no formation of a bird's beak structure at the photodiode 503 interface to the transfer gate 206. Note also that in one embodiment, there is also a bird's beak structure at the interface between the reset gate of the reset transistor and the floating node 501.

After the re-oxidation step, the protective layer 401 can be removed. Note that there is some ancillary oxide 505 formation on the side walls and the top of the transfer gate 206 in the reset gate. This ancillary oxide 505 may need to be removed to allow contact to the polysilicon gate material.

From the foregoing, it will be appreciated that specific embodiments of the invention have been described herein for purposes of illustration, but that various modifications may be made without deviating from the scope of the invention. Accordingly, the invention is not limited except as by the appended claims.

## Claims

1. A method of forming an active pixel comprising:
forming a photodiode (503) in an active area of a semiconductor substrate;
forming a transfer transistor between said photodiode (503) and a floating node (501), said transfer transistor having a gate oxide with a bird's beak structure formed at an interface of its transfer gate (206) and said floating node (501); and
forming a reset transistor (113) operative for resetting said floating node (501) to a voltage reference.

2. The method of Claim 1 wherein the gate oxide of said transfer transistor does not have a bird's beak structure at an interface of the transfer gate (206) and said photodiode (503).

3. The method of Claim 1 wherein said reset transistor has a gate oxide with a bird's beak structure at both sides of its reset gate.

4. The method of Claim 1 wherein said bird's beak structure is formed using a thermal re-oxidation.

5. The method of claim 1 further comprising:
forming an isolation (203) in the semiconductor substrate to define the active area;
forming a gate oxide over said active area;
forming a polysilicon layer over said gate oxide; and
patterning said polysilicon layer to form the transfer gate (206) and the reset gate;
forming the photodiode (503) in said semiconductor substrate to be adjacent to said transfer gate (206);
forming the floating node (501) to be between said transfer gate (206) and said reset gate;
forming a protective layer (401) over the interface of said transfer gate (206) and said photodiode (503);
forming the bird's beak structure at the interface of said transfer gate (206) and said floating node (501) by performing a re-oxidation process.

6. The method of Claim 5 further including removing said protective layer (401) after said re-oxidation process.

7. The method of Claim 6 wherein said protective layer (401) is a nitride.

8. The method of Claim 5 further wherein said re-oxidation process also forms a bird's beak structure in the gate oxide at an interface of said reset gate and said floating node (501).

9. A pixel comprising:
a photodiode (503);
a transfer transistor formed between said photodiode (503) and a floating node (501) and selectively operative to transfer a signal from said photodiode (503) to said floating node (501), said transfer transistor having a gate oxide with a bird's beak structure formed at the interface of its transfer gate (206) and said floating node (501);
a reset transistor for resetting said floating node (501) to a voltage reference; and
an amplification transistor (103) controlled by said floating node (501).

10. The pixel of Claim 9 wherein the gate oxide of said transfer transistor does not have a bird's beak structure at an interface of the transfer gate (206) and said photodiode (503).

11. The pixel of Claim 9 wherein said reset transistor (113) has a gate oxide with a bird's beak structure at both sides of its reset gate.

12. The pixel of Claim 9 wherein said bird's beak structure is formed using a thermal oxidation.

## Patentansprüche

1. Verfahren zur Ausbildung eines aktiven Pixels, umfassend:
das Ausbilden einer Photodiode (503) in einem aktiven Bereich eines Halbleitersubstrats;
das Ausbilden eines Transfertransistors zwischen der Photodiode (503) und einem potentialungebundenen Knoten (501), wobei der Transfertransistor ein Gate-Oxid mit Vogelschnabelstruktur aufweist, das an einer Grenzfläche seines Transfergates (206) und des potentialungebundenen Knotens (501) ausgebildet ist; und
das Ausbilden eines Rückstelltransistors (113), der zum Rückstellen des potentialungebundenen Knotens (501) auf eine Referenzspannung fungiert.

2. Verfahren nach Anspruch 1, worin das Gate-Oxid des Transfertransistors keine Vogelschnabelstruktur an der Grenzfläche des Transfergates (206) und der Photodiode (503) aufweist.

3. Verfahren nach Anspruch 1, worin der Rückstelltransistor an beiden Seiten seines Rückstellgates ein Gate-Oxid mit Vogelschnabelstruktur aufweist.

4. Verfahren nach Anspruch 1, worin die Vogelschnabelstruktur unter Einsatz einer thermischen Reoxidation ausgebildet wird.

5. Verfahren nach Anspruch 1, ferner umfassend:
das Ausbilden einer Isolierung (203) in dem Halbleitersubstrat zur Definition des aktiven Bereichs;
das Ausbilden eines Gate-Oxids über dem aktiven Bereich;
das Ausbilden einer Polysiliciumschicht über dem aktiven Gate-Oxid;
und das Strukturieren der Polysiliciumschicht zur Ausbildung des Transfergates (206) und des Rückstellgates;
das Ausbilden der Photodiode (503) in dem Halbleitersubstrat, sodass diese in Bezug auf das Transfergate (206) benachbart vorliegt;
das Ausbilden des potentialungebundenen Knotens (501), sodass dieser zwischen dem Transfergate (206) und dem Rückstellgate vorliegt;
das Ausbilden einer Schutzschicht (401) über der Grenzfläche des Transfergates (206) und der Photodiode (503);
das Ausbilden der Vogelschnabelstruktur an der Grenzfläche des Transfergates (206) und des potentialungebundenen Knotens (501) durch die Durchführung eines Reoxidationsverfahrens.

6. Verfahren nach Anspruch 5, ferner umfassend das Entfernen der Schutzschicht (401) nach dem Reoxidationsverfahren.

7. Verfahren nach Anspruch 6, worin die Schutzschicht (401) ein Nitrid ist.

8. Verfahren nach Anspruch 5, worin durch das Reoxidationsverfahren auch eine Vogelschnabelstruktur an der Grenzfläche des Rückstellgates und des potentialungebundenen Knotens (501) in dem Gate-Oxid ausgebildet wird.

9. Pixel, umfassend:
eine Photodiode (503);
einen Transfertransistor, der zwischen der Photodiode (503) und einem potentialungebundenen Knoten (501) ausgebildet ist und wahlweise betätigt werden kann, um ein Signal von der Photodiode (503) an den potentialungebundenen Knoten (501) weiterzuleiten, wobei der Transfertransistor ein Gate-Oxid mit Vogelschnabelstruktur aufweist, das an der Grenzfläche seines Transfergates (206) und des potentialungebundenen Knotens (501) ausgebildet ist;
einen Rückstelltransistor zum Rückstellen des potentialungebundenen Knotens (501) auf eine Referenzspannung; und
einen Verstärkungstransistor (103), der durch den potentialungebundenen Knoten (501) gesteuert wird.

10. Pixel nach Anspruch 9, worin das Gate-Oxid des Transfertransistors an der Grenzfläche des Transfergates (206) und der Photodiode keine Vogelschnabelstruktur aufweist.

11. Pixel nach Anspruch 9, worin der Rückstelltransistor (113) an beiden Seiten seines Rückstellgates ein Gate-Oxid mit Vogelschnabelstruktur aufweist.

12. Pixel nach Anspruch 9, worin die Vogelschnabelstruktur unter Einsatz einer thermischen Oxidation ausgebildet wird.

## Revendications

1. Procédé de formation d'un pixel actif consistant à:
former une photodiode (503) dans une zone active d'un substrat semi-conducteur;
former un transistor de transfert entre ladite photodiode (503) et un noeud flottant (501), ledit transistor de transfert comportant un oxyde de grille avec une structure en bec d'oiseau formée au niveau d'une interface de sa grille de transfert (206) et dudit noeud flottant (501); et
former un transistor de réinitialisation (113) pouvant être utilisé pour réinitialiser ledit noeud flottant (501) à une référence de tension.

2. Procédé selon la revendication 1, dans lequel l'oxyde de grille dudit transistor de transfert n'a pas une structure en bec d'oiseau au niveau d'une interface de la grille de transfert (206) et de ladite photodiode (503).

3. Procédé selon la revendication 1, dans lequel ledit transistor de réinitialisation comporte un oxyde de grille avec une structure en bec d'oiseau des deux côtés de sa grille de réinitialisation.

4. Procédé selon la revendication 1, dans lequel ladite structure en bec d'oiseau est formée en utilisant une réoxydation thermique.

5. Procédé selon la revendication 1 consistant en outre à:
former un isolant (203) dans le substrat semi-conducteur pour définir la zone active;
former un oxyde de grille sur ladite zone active;
former une couche de polysilicium sur ledit oxyde de grille; et
dessiner ladite couche de polysilicium pour former la grille de transfert (206) et la grille de réinitialisation;
former la photodiode (503) dans ledit substrat semi-conducteur de manière à ce qu'elle soit adjacente à ladite grille de transfert (206);
former le noeud flottant (501) de manière à ce qu'il soit entre ladite grille de transfert (206) et ladite grille de réinitialisation;
former une couche de protection (401) sur l'interface de ladite grille de transfert (206) et de ladite photodiode (503);
former la structure en bec d'oiseau au niveau de l'interface de ladite grille de transfert (206) et dudit noeud flottant (501) en effectuant un processus de réoxydation.

6. Procédé selon la revendication 5, comprenant en outre le retrait de ladite couche de protection (401) après ledit processus de réoxydation.

7. Procédé selon la revendication 6, dans lequel ladite couche de protection (401) consiste en du nitrure.

8. Procédé selon la revendication 5, dans lequel, en outre, ledit processus de réoxydation forme également une structure en bec d'oiseau dans l'oxyde de grille au niveau d'une interface de ladite grille de réinitialisation et dudit noeud flottant (501).

9. Pixel comprenant:
une photodiode (503);
un transistor de transfert formé entre ladite photodiode (503) et un noeud flottant (501) et pouvant être utilisé de manière sélective pour transférer un signal de ladite photodiode (503) audit noeud flottant (501), ledit transistor de transfert comportant un oxyde de grille avec une structure en bec d'oiseau formée au niveau de l'interface de sa grille de transfert (206) et dudit noeud flottant (501);
un transistor de réinitialisation pour réinitialiser ledit noeud flottant (501) à une référence de tension; et
un transistor d'amplification (103) commandé par ledit noeud flottant (501).

10. Pixel selon la revendication 9, dans lequel l'oxyde de grille dudit transistor de transfert n'a pas une structure en bec d'oiseau au niveau d'une interface de la grille de transfert (206) et de ladite photodiode (503).

11. Pixel selon la revendication 9, dans lequel ledit transistor de réinitialisation (113) comporte un oxyde de grille avec une structure en bec d'oiseau des deux côtés de sa grille de réinitialisation.

12. Pixel selon la revendication 9, dans lequel ladite structure en bec d'oiseau est formée en utilisant une oxydation thermique.
